(19) Europäisches Patentamt
European Patent Office
Office européen des brevets

(11) Veröffentlichungsnummer: **0 031 065**
**B1**

(12) # EUROPÄISCHE PATENTSCHRIFT

(45) Veröffentlichungstag der Patentschrift: **12.10.83**

(51) Int. Cl.³: **H 01 L 29/28,** H 01 L 31/02

(21) Anmeldenummer: **80107719.9**

(22) Anmeldetag: **08.12.80**

(54) **Naphthalintetracarbonsäurediimide als elektrische Halbleiter und Photoleiter.**

(30) Priorität: **20.12.79 DE 2951349**

(43) Veröffentlichungstag der Anmeldung: **01.07.81 Patentblatt 81/26**

(45) Bekanntmachung des Hinweises auf die Patenterteilung: **12.10.83 Patentblatt 83/41**

(84) Benannte Vertragsstaaten: **CH DE FR GB IT LI**

(56) Entgegenhaltungen:
DE-A-1 230 031
DE-A-2 059 540
FR-A-2 361 749

(73) Patentinhaber: **BAYER AG, Zentralbereich Patente, Marken und Lizenzen, D-5090 Leverkusen 1, Bayerwerk (DE)**

(72) Erfinder: **Hocker, Jürgen, Dr., Eichenweg 6, D-5060 Bergisch Gladbach 2 (DE)**
Erfinder: **Merten, Rudolf, Dr., Berta-von-Suttner-Strasse 55, D-5090 Leverkusen 1 (DE)**
Erfinder: **Fitzky, Hans Georg, Dr., Adolf-Kolping-Strasse 7, D-5068 Odenthal (DE)**
Erfinder: **Müller, Hans Klaus, Dr., August-Kierspel-Strasse 149, D-5060 Bergisch Gladbach 2 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 031 065 B1

ACTORUM AG

# Naphthalintetracarbonsäurediimide als elektrische Halbleiter und Photoleiter

Gegenstand der Erfindung ist die Verwendung von Naphthalintetracarbonsäurediimiden der Formel I:

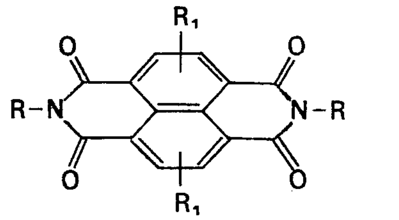

(I)

worin:

R ein gesättigter oder olefinisch ungesättigter aliphatischer oder cycloaliphatischer Rest ist, vorzugsweise mit bis zu 12, insbesondere mit bis zu 8 C-Atomen, der eine Elektronendonatorgruppe enthalten muss, und die Reste $R^1$, unabhängig voneinander, Wasserstoff, $C_1$-$C_4$-Alkyl, Halogen, $NO_2$, $SO_3H$, CN, $COOR^2$, $NR^2$ ($R^2$ = Wasserstoff, $C_1$-$C_4$-Alkyl), Hydroxyl, $C_1$-$C_4$-Alkoxy bedeuten, als elektrische Halbleiter oder Photoleiter.

Elektronendonatorgruppe in den Resten R kann ein Heteroatom sein, wie $-O-$, $-S-$ oder $-NR^3-$ ($R^3$ = Wasserstoff, $C_1$-$C_6$-Alkyl oder $CR^5O$ mit $R^5$ = Wasserstoff, $C_1$-$C_{12}$-Alkyl bzw. $C_1$-$C_{12}$-Alkylen). $-NR^3-$ kann für $R^3$ = Wasserstoff, $C_1$-$C_6$-Alkyl nach Umsetzung mit einer anorganischen oder organischen Säure bzw. mit einem Alkylierungsmittel auch als Ammonium-Ion $-NR^3R^4-$ mit $R^4$ = Wasserstoff, $C_1$-$C_4$-Alkyl und einem anorganischen bzw. organischen Anion einschliesslich dem Radikal-Anion des Tetracyanochinodimethans (TCNQ) vorliegen, wobei im Falle des TCNQ neben dem Radikal-Anion noch eine äquivalente Menge neutrales TCNQ vorliegen kann.

Besonders geeignet für die Verwendung als Halbleiter oder Photoleiter sind Naphthalin-1.4.5.8-tetracarbonsäurediimide mit R = $-(CH_2)_x-N(CH_3)_2$ mit x = 2–12:

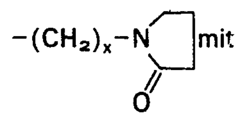 mit x = 2, 3, 4 und 6

$-CH_2-CH_2-OH$ bzw. $-CH_2-CH_2-OCH_3$

$-CH_2-CH_2-S-CH_3$

Die spezifische Leitfähigkeit typischer organischer Verbindungen ist kleiner als $10^{-12}$ $Ohm^{-1}$ $cm^{-1}$, so dass sie elektrische Isolatoren sind. Die erfindungsgemäss zu verwendenden Stoffe haben dagegen spezifische Leitfähigkeiten von $>10^{-12}$ $\Omega^{-1}$ $cm^{-1}$, die bei Belichtung noch um einen Faktor 2 bis 100 grösser werden. Demnach sind diese Substanzen insbesondere geeignet für Reproduktionstechniken wie z.B. zur Herstellung von Photokopien sowie für optoelektronische Bauelemente wie z.B. Photozellen, Lichtschranken u.a.

Die erfindungsgemäss zu verwendenden Substanzen sind bekannt, z.B. aus den DE-AS 1 230 031; 1 195 762; und den DE-OS 1 445 768 und 1 445 769.

*Beispiel 1:*

710 Gew.-Teile Naphthalin-1,4,5,8-tetracarbonsäure und 830 Gew.-Teile N-Hexylaminopyrrolidon werden in 1900 Vol.-Teilen Dimethylformamid 2 Stunden unter Rückfluss zum Sieden erhitzt. Nach dem Abkühlen filtriert man, wäscht den Rückstand mit Dimethylformamid, dann mit Äther und erhält 1270 Gew.-Teile des Diimids II:

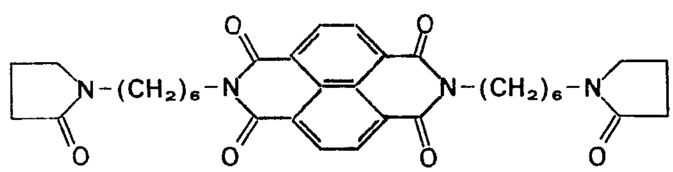

(II)

Die Mikrowellenleitfähigkeitsmessung am Pulver ergibt eine Dunkelleitfähigkeit von $\sim 0{,}3 \cdot 10^{-3}$ $Ohm^{-1}$ $cm^{-1}$. Nach 20 min Belichten mit einer Xenonhochdrucklampe steigt die Leitfähigkeit auf $0{,}55 \cdot 10^{-3}$ $Ohm^{-1}$ $cm^{-1}$ an (Messfrequenz 9 GHz).

*Beispiel 2:*

Das analog Beispiel 1 hergestellte Diimid III zeigt eine Dunkelleitfähigkeit von $\sim 0{,}3 \cdot 10^{-3}$ $Ohm^{-1}$ $cm^{-1}$; die nach 20minütigem Belichten auf $5{,}5 \cdot 10^{-3}$ $Ohm^{-1}$ $cm^{-1}$ (Mikrowellenleitfähigkeitsmessung) ansteigt:

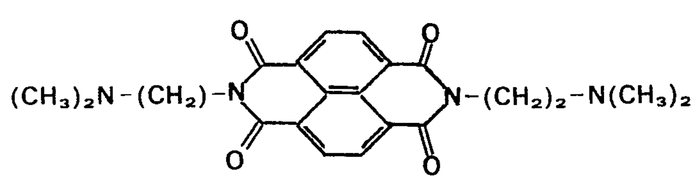

(III)

*Beispiel 3:*

Das analog Beispiel 1 aus dem Naphthalin-1,4,5,8-tetracarbonsäuredianhydrid hergestellte Diimid IV zeigt eine Dunkelleitfähigkeit (pulverförmige Probe, Mikrowellenleitfähigkeitsmessung, Messfrequenz 9 GHz) von 1,9 · $10^{-3}$ $Ohm^{-1}$ $cm^{-1}$, die nach 20minütigem Belichten mit einer Xenonhochdrucklampe auf 67 · $10^{-3}$ $Ohm^{-1}$ $cm^{-1}$ ansteigt.

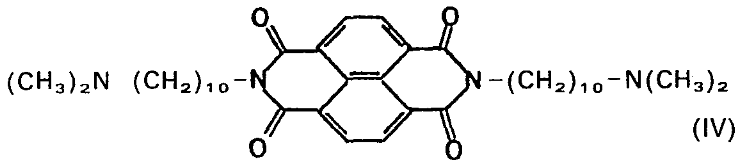

(IV)

Die erfindungsgemässen Diimide lassen sich als optoelektronische Bausteine in elektronischen Schaltelementen bzw. als Photoleiter in Reproduktionsgeräten anwenden.

**Patentanspruch**

Verwendung von Naphthalintetracarbonsäurediimiden der Formel I:

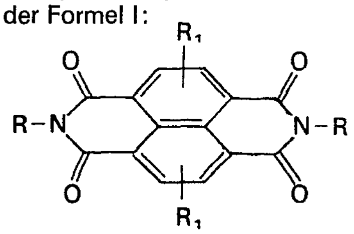

(I)

worin:

R ein gesättigter oder olefinisch ungesättigter aliphatischer oder cycloaliphatischer Rest ist, der eine Elektronendonatorgruppe enthält, und die Reste $R^1$—unabhängig voneinander— Wasserstoff, Halogen, $NO_2$, $SO_3H$, CN, $COOR^2$, $NR^2$ ($R^2$ = Wasserstoff, $C_1$-$C_4$-Alkyl), Hydroxyl, $C_1$-$C_4$-Alkoxy bedeuten, als elektrische Halbleiter oder Photoleiter.

**Claim**

Use of naphthalene tetracarboxylic acid diimides of the formula I:

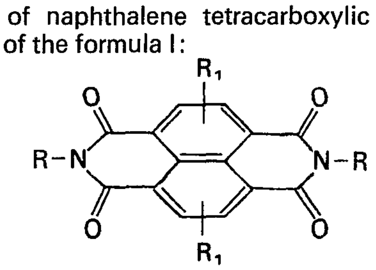

(I)

wherein:

R is a saturated or olefinically unsaturated aliphatic or cycloaliphatic radical which contains an electron donor group, and the radicals $R^1$—independently of one another— denote hydrogen, halogen, $NO_2$, $SO_3H$, CN, $COOR^2$, $NR^2$ ($R^2$ = hydrogen, $C_1$-$C_4$-alkyl), hydroxyl or $C_1$-$C_4$-alkoxy, as electrical semiconductors or photoconductors.

**Revendication**

Utilisation de diimides d'acide naphtalène-tétracarboxylique de formule I:

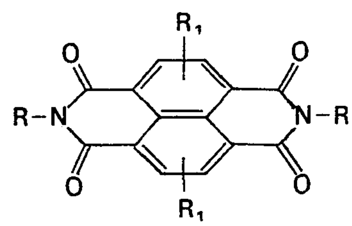

(I)

dans laquelle:

R est un reste aliphatique ou cycloaliphatique saturé ou à non-saturation oléfinique, qui renferme un groupe donneur d'électrons, et les restes $R^1$, indépendamment l'un de l'autre, représentent l'hydrogène, un halogène, un groupe $NO_2$, $SO_3H$, CN, $COOR^2$, $NR^2$ ($R^2$ = hydrogène, alkyle en $C_1$ à $C_4$), hydroxyle, alkoxy en $C_1$ à $C_4$, comme semiconducteurs électriques ou photoconducteurs.